# EUROPÄISCHE PATENTSCHRIFT

(11) **EP 0 891 286 B1**
(45) Veröffentlichungstag und Bekanntmachung des Hinweises auf die Patenterteilung: **31.05.2000**
(21) Anmeldenummer: 97914307.0
(22) Anmeldetag: 25.03.1997
(51) Int. Cl.: B65H 1/22, H03K 17/945

(54) **FADENLIEFERGERÄT MIT EINEM MAGNETISCHEN NÄHERUNGSSENSOR**
YARN FEEDER WITH A PROXIMITY SENSOR
FOURNISSEUR DE FIL MUNI D'UN DETECTEUR DE PROXIMITE MAGNETIQUE

(30) Priorität: 26.03.1996 DE 19611998; 19.07.1996 DE 29612566 U
(43) Veröffentlichungstag der Anmeldung: 20.01.1999
(73) Patentinhaber: IRO AB, 523 01 Ulricehamn (SE)
(72) Erfinder: HALVARSSON, Björn, S-523 30 Ulricehamn (SE)
(74) Vertreter: Kinkeldey, Hermann, Dr.-Ing.
(86) Internationale Anmeldenummer: EP9701521
(87) Internationale Veröffentlichungsnummer: WO9735793

(56) Entgegenhaltungen:
- EP-A- 0 171 516
- DE-A- 3 911 411
- US-A- 4 213 110
- US-A- 5 172 052

## Beschreibung

Die Erfindung betrifft ein Fadenliefergerät gemäß Oberbegriff des Patentanspruchs 1.

Näherungssensoren werden in der fadenverarbeitenden Technik in großem Umfang zur Fadendetektion oder Bewegungsdetektion eingesetzt. EP-B-171 516 betrifft ein Fadenliefergerät, bei dem mehrere Näherungssensoren zum Steuern des Antriebsmotors des Aufwickelelements die Größe eines auf der Speichertrommel gebildeten Fadenvorrats abtasten (Minimal-, Maximal- oder Referenz-Vorratsgrößen-Sensor). Dabei wird der jeweils ein Hallelement des Näherungssensors zum Ansprechen bringende Magnet, z.B. ein Permanentmagnet, durch den Fadenvorrat aus einer ersten Lage, in der der Magnet dem Hallelement näher ist, in eine zweite Lage bewegt, in der er vom Hallelement weiter entfernt ist. Auf diese Bewegung spricht das Hallelement digital oder analog an. Der Näherungssensor erzeugt ein Signal, das den Antriebsmotor steuert (einschaltet oder abschaltet, beschleunigt oder verzögert). Häufig ist in einem solchen Fadenliefergerät femer ein Näherungssensor als Geschwindigkeits- oder Zählsensor vorgesehen, der jeweils auf den Durchgang des mit der Antriebswelle oder dem Aufwickelelement rotierenden Magneten mit einem Signal anspricht. Solche Näherungssensoren sind außerordentlich zuverlässige elektronische Komponenten, wobei aus Kostengründen meist ein Hallelement, aber auch ein magnetoresistives Sensorelement oder ein induktives Sensorelement benutzt werden kann, um aus der relativen Bewegung eines Körpers aus einem magnetischen und/oder elektromagnetischen Fluß leitendem Material Signale zu gewinnen. Es zeigt sich in der Praxis, daß in einer Baureihe von Fadenliefergeräten oder unter den mehreren Näherungssensoren in ein und demselben Fadenliefergerät die Ansprechempfindlichkeit der Näherungssensoren streut. Dies liegt vermutlich an den Näherungssensoren und gegebenenfalls auch an Herstellungs- oder Montagetoleranzen. Beispielsweise liegt bei einem Näherungssensor als Maximal-Vorratsgrößensensor der Umschaltpunkt bei einem anderen Abstand zwischen dem Hallelement und dem Magneten, als bei dem gleichen Maximal-Vorratsgrößensensor eines weiteren Fadenliefergeräts derselben Bauserie. Dies kann sogar zwischen den Näherungssensoren in ein und demselben Fadenliefergerät auftreten. Es ist wünschenswert, zwischen den Näherungssensoren in ein und demselben Fadenliefergerät dasselbe Ansprechverhalten zu haben, oder unter den gleichen Näherungssensoren in verschiedenen Fadenliefergeräten einer Baureihe dasselbe Ansprechverhalten gewährleisten zu können, damit die Motorsteuerung jeweils identisch erfolgt. Bei der Verwendung von Näherungssensoren mit einem Hallelement ist es in der Praxis generell bekannt, das Ansprechen des Hallelements durch einen in der Nähe des Hallelements angebrachten Metallkörper durch Konzentrieren des magnetischen Flusses zu verbessern.

Aus US-A-4 213 110 ist eine Reed-Schaltvorrichtung für ein Sicherheits-Überwachungssystem oder eine Maschinensteuerung bekannt, bei der dem eingekapselten Reed-Schalter ein Vorspannmagnet zugeordnet ist. Der Vorspannmagnet läßt sich parallel zur Längsrichtung des Reed-Schalters mittels einer Stellschraube verfahren, um die Empfindlichkeit des Reed-Schalters zu verstellen.

Aus US-A-5 712 052 ist ein Stromsensor bekannt, mit dem der Strom in Leitungen berührungslos abtastbar ist. Zwischen den Leitungen eines Leitungspaares ist ein Hallelement angeordnet, das die Form eines flachen viereckigen Prismas hat. Zum Konzentrieren oder Richten des Magnetflusses ist dem Hallelement eine Stellschraube zugeordnet. Durch Verstellen der Stellschraube in ihrer Längsrichtung läßt sich die Flußdichte in dem Hallelement erhöhen oder Verringern, um die Empfindlichkeit des Stromsensors einzustellen.

Der Erfindung liegt die Aufgabe zugrunde, ein Fadenliefergerät zu schaffen, bei dem auf baulich einfache Weise das Ansprechverhalten des Näherungssensors änderbar oder innerhalb einer Fadenliefergerät-Bauserie gleiche Ansprechverhalten der Näherungssensoren herstellbar sind.

Die gestellte Aufgabe wird erfindungsgemäß mit den Merkmalen des Patentanspruchs 1 gelöst.

Durch Veränderung des Abstands zwischen dem Trimmkörper und dem Sensorelement läßt sich am Fadenliefergerät die Ansprechempfindlichkeit des jeweiligen Sensorelementes verändern bzw. der Umschaltpunkt auf einen bestimmten Abstand zwischen dem Sensorelement und dem Magneten bzw. dem Eisenkörper einstellen. Sollte in einer Serie von Fadenliefergeräten unter den Näherungssensoren eine Streuung vorliegen, so läßt sich die Streuung nachträglich nivellieren. Innerhalb einer Bauserie oder in einem Fadenliefergerät sind identische Ansprechverhalten der Näherungssensoren untereinander erzielbar. Das Ansprechverhalten läßt sich mittels des Trimmkörpers nachträglich gewollt an bestimmte Verhältnisse anpassen, falls dies für den jeweiligen Einsatzfall zweckmäßig ist. Günstig ist, daß die Veränderung der Ansprechempfindlichkeit bei bereits funktionsgerecht eingebautem Fadensensor, Geschwindigkeits- oder Zählsensor jederzeit, d.h. auch nachträglich, möglich ist. Der Tnmmkörper sollte ein magnetischen oder elektromagnetischen Fluß leitendes Material aufweisen, z.B. Metall. Das Sensorelement kann ein Hallelement oder ein magnetoresistives oder induktives Sensorelement sein. Mit den Signalen des Fadensensors wird der Antriebsmotor des Fadenliefergeräts gesteuert. Durch die Verstellung des Trimmkörpers lassen sich Fadensensoren innerhalb einer Baureihe von Fadenliefergeräten oder in demselben Fadenliefergerät nachträglich abstimmen, um identische Steuerungsverhältnisse mit den Näherungssensoren oder für die Antriebsmotoren der Fadenliefergeräte der Bauserie zu erreichen. In einer Bauserie von Fadenliefergeräten lassen sich bei streuenden Geschwindigkeits- oder Zählsensoren mittels der Trimmkörper identische Ansprechverhalten nachträglich herstellen, bzw. generell z.B. durch Fertigungs- und Montagetoleranzen bedingte Streuungen im Ansprechverhalten der Sensoren nachträglich beseitigen.

Die Handhabung ist gemäß Anspruch 3 zweckmäßig, weil sich der Sensor jederzeit bequem trimmen läßt.

Gemäß Anspruch 4 fungiert eine Schraube als Träger des Trimmkörpers.

Gemäß Anspruch 5 kann der Trimmkörper nach Art eines Bajonettverschlusses, einer Exzenterverstellung oder dgl. relativ zum Sensorelement bewegt werden. D.h., daß das Trimmelement nicht notwendigerweise eine Schraube in einer Gewindebohrung, sondern ein einfacher Metallkörper mit dem Eingriffselement sein kann und sich relativ zum Sensorelement verstellen läßt. Denkbar wäre es femer, eine Schraubspindel oder eine Schraube nur als Antrieb für den davon getrennten und damit in Eingriff stehenden, beweglich geführten Trimmkörper zu verwenden.

Die Ausführungsform gemäß Anspruch 6 ist kompakt und spart Einbauraum. Die Gewindebohrung hat eine Doppelfunktion, da sie auch zur Positionierung des Sensorelementes dient.

Zweckmäßigerweise sitzt der Trimmkörper in einer Halterung aus "neutralem Material", z.B. Kunststoff, und erfolgt seine Verstellung mit einem Werkzeug, das wenigstens an der angreifenden Spitze aus "neutralem Material" besteht, um das Resultat der Einstellung nicht zu verfälschen.

Anhand der Zeichnung werden Ausführungsformen des Erfindungsgegenstandes erläutert. Es zeigen:
- Fig. 1: eine schematische Seitenansicht, teilweise im Schnitt, eines Fadenliefergeräts mit Näherungssensoren, z.B. mit Hallelementen, und
- Fig. 2: einen Teilschnitt aus Fig. 1, der Komponenten eines Näherungssensors mehr im Detail zeigt.

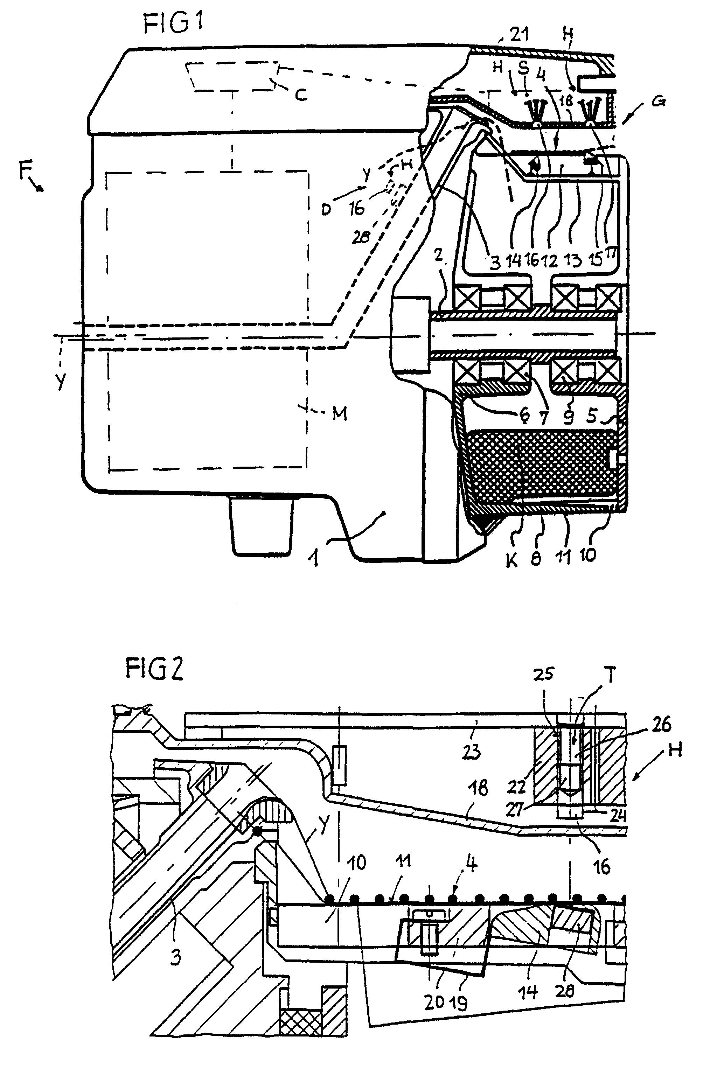

Ein Fadenliefergerät F gemäß Fig. 1 weist ein Gehäuse 1 auf, in dem eine Antriebswelle 2 drehbar gelagert und mittels eines Antriebsmotors M zur Drehung antreibbar ist. Die Antriebswelle 2 trägt ein schräg nach außen geführtes Fadenaufwickelelement 3. Der in das Gehäuse 1 in Fig. 1 von links einlaufende Faden Y durchsetzt das Aufwickelelement 3 und wird bei dessen Rotation in nebeneinanderliegenden Windungen in einem Fadenvorrat 4 auf die Oberfläche 11 einer Speichertrommel 5 aufgewickelt, die drehbar auf der Antriebswelle 2 gelagert und durch nicht dargestellte Mittel am Mitdrehen gehindert wird (stationäre Speichertrommel). Ein Fadenliefergerät einer anderen Art (nicht gezeigt) könnte jedoch auch mit einer mit der Antriebswelle 2 rotierenden Speichertrommel und stationärem Aufwickelelement 3 betrieben werden.

Die Oberfläche 11 der Speichertrommel 5 ist bei dieser Ausführungsform durch axiale und ineinandergreifende Stäbe 10, 8 definiert. Die Stäbe 8 sind in einer Nabe 6 angebracht, die mit Lagern 7 auf der Antriebswelle 2 drehbar angeordnet ist, und zwar mit einer Schrägstellung und einer Exzentrizität. Die Stäbe 10 sind hingegen an einer über Lager 9 auf der Antriebswelle koaxial angeordneten Nabe angebracht. Dank der Schrägstellung und der Exzentrizität führen die Stäbe 8 bei der Drehbewegung der Antriebswelle 2 eine periodische Taumelbewegung relativ zu den Stäben 10 aus, durch die die Fadenwindungen auf der Speichertrommel in Fig. 1 nach rechts vorwärts gefördert und voneinander separiert werden.

Dem Aufwickelement 3 kann ein Geschwindigkeits- oder Zählsensor Sensorelement 16 aufweist, das auf einen am Aufwickelelement 3 angeordneten Magneten 28 ausgerichtet ist und bei jedem Durchgang des Aufwickelelements ein Signal erzeugt.

Ferner sind in einem Ausleger 21 des Gehäuses 1 Fadensensoren G angeordnet, die zwei Näherungssensoren H mit Sensorelementen 16 und 17 und zugeordnete Fühlelemente 14, 15 aufweisen, z.B. Hallsensoren mit Hallelementen. Die Näherungssensoren H sind in eine Sensorschaltung S eingegliedert, die an eine Steuervorrichtung C zum Steuern des Antriebsmotors M angeschlossen ist. Jedes Fühlelement 14, 15 ist durch den Fadenvorrat 4 aus einer, z.B. über die Oberfläche 11 der Speichertrommel 5 vorstehenden, Position (s. Fühlelement 15) in eine der Achse der Speichertrommel 5 näherliegende Position bewegbar. Auf diese Bewegung spricht der zugeordnete Näherungssensor H bzw. dessen Sensorelement 16 bzw. 17 an, um für die Steuervorrichtung C Steuersignale zu erzeugen. In Fig. 1 reicht der Fadenvorrat 4 gerade bis zum Fühlelement 15, das noch nicht nach innen verlagert wurde. Die Mindestgröße des Vorrats wird vom Fühlelement 14 überwacht, das bei entsprechender Verkleinerung des Fadenvorrats aufgrund Verbrauchs freigegeben wird und sich dann dem Sensorelement 16 nähert, worauf dieses ein Signal erzeugt, mit dem der Antriebsmotor M entweder beschleunigt oder eingeschaltet wird. Beim Verlegen des Fühlelements 15 durch den Faden nach innen wird hingegen der Antriebsmotor M stillgesetzt oder verzögert. Die Sensorelemente 16, 17 sind in einer Abdeckung 18 oder knapp dahinter angeordnet. Durch Streuung oder/und Fertigungs- und Montagetoleranzen können innerhalb einer Bauserie von Fadenliefergeräten oder zwischen Näherungssensoren in demselben Fadenliefergerät die Abstände zwischen dem Fühlelement 14 bzw. 15 und dem Sensorelement 16 bzw. 17 variieren, bei denen der jeweilige Umschaltpunkt des Näherungssensors (digitales Schalten) erreicht wird, wodurch sich innerhalb der Bauserie oder zwischen den Näherungssensoren unerwünschte Unterschiede der Steuerung der Antriebsmotoren M ergeben. Um diese Unterschiede beseitigen zu können, ist (Fig. 2) bei jedem Sensorelement 16 ein Trimmkörper T derart angeordnet, daß er sich hinsichtlich seines Abstandes vom Sensorelement 16 verstellen läßt. Der Trimmkörper T besteht, zumindest zu einem erheblichen Teil, aus magnetischen oder elektromagnetischen Fluß leitenden Material, z.B. aus Metall, und beeinflußt das Ansprechverhalten des Sensorelements 16. Durch eine Abstandsverstellung des Trimmkörpers relativ zum Sensorelement 16 läßt sich dessen Ansprechverhalten verändern, so daß die vorerwähnte Streuung der Näherungssensoren durch Trimmen mittels der Trimmkörper T beseitigbar ist. Der Umschaltpunkt des Näherungssensors läßt sich jedoch mit dem Trimmkörper T - bei Bedarf - auch bewußt verlagern.

In sehr vielen Fällen ist das Sensorelement 16, 17 ein Hallelement, das auf eine Veränderung der Dichte des es beaufschlagenden Magnetfeldes anspricht. Genausogut kann aber auch ein magnetoresistives oder ein induktives Sensorelement benutzt werden, d.h. jedes Sensorelement, das in der Lage ist, abhängig vom Abstand eines Körpers aus einem magnetischen und/oder elektromagnetischen Fluß leitendem Material ein elektrisches Signal abzugeben.

In Fig. 2 ist eine Halterung 22 für das Sensorelement 16, z.B. ein Hallelement eines Hallsensors H, an einer Platte 23 angeordnet. Die Halterung 22 weist eine Gewindebohrung 25 auf, in die als Trimmkörper T eine Schraube 26 aus Metall eingeschraubt ist. Zweckmäßig sitzt die Schraube 26 in für das Ansprechverhalten des Sensorelements 16 "neutralem" Werkstoff, z.B. Kunststoff, und erfolgt die Verstellung mit einem Werkzeug aus "neutralem" Material. Das Sensorelement 16 befindet sich an der Mündung der Gewindebohrung 25 und reagiert in seinem Ansprechverhalten auf die Nähe des Trimmkörpers T. Gegebenenfalls fungiert die Schraube 26 nur als Träger und Antrieb einer Metallmasse 27. Durch Verschrauben der Schraube 26 in der mit ihrer Achse auf das Sensorelement 16 ausgerichteten Gewindebohrung 25 läßt sich der Abstand des Trimmkörpers T zum Sensorelement 16 verändern. Die erzeugten Signale werden über eine Leitung 24 zur Sensorschaltung S (Fig. 1) übertragen. Die Abdeckung 18 befindet sich in diesem Fall im Abstand vor dem Sensorelement 16.

Das Fühlelement 14 enthält einen Magneten 28, z.B. einen Permanentmagneten, dessen Magnetfeld das Sensorelement 16 zum Ansprechen bringt. Das Fühlelement 14 ist an einem Federarm 19 angebracht, der bei 20 in einem der Stäbe 10 der Speichertrommel 5 gelagert ist. Die Fadenwindungen im Fadenvorrat 4 verlagern bei der dargestellten Größe des Fadenvorrats 4 das Fühlelement 14 nach unten, so daß das Sensorelement 16 schwächer vom Magnetfeld des Magneten 28 beaufschlagt wird. Verkleinert sich der Fadenvorrat 4 so weit, daß das Fühlelement 14 frei wird, dann drückt der Federarm 19 das Fühlelement 14 mit dem Magneten 28 nach oben, bis das Sensorelement 16 auf die zunehmende Intensität des Magnetfelds des Magneten 28 anspricht, den Umschaltpunkt überschreitet und ein Signal erzeugt. Durch Verschrauben des Trimmkörpers T läßt sich die Ansprechempfindlichkeit verändern.

Der Trimmkörper T könnte nach Art eines Bajonetteingriffes in seinem Abstand zum Sensorelement 16 verstellbar sein. Ferner ist es denkbar, eine geführte Metallkugel oder Metallmutter auf einer Schraube oder Schraubspindel anzuordnen und durch Drehen der Schraube oder Schraubspindel, die selbst nicht axial beweglich ist, näher zum Sensorelement 16 zu bringen oder weiter von diesem entfernen. Auch eine Verstellung mittels eines Hebels oder eines Exzenters wäre für den Trimmkörper T denkbar.

Es wird durch Verstellen des Trimmkörpers relativ zum Sensorelement das Ansprechverhalten des Sensorelements auf einfache Weise verändert, zweckmäßigerweise zu dem Zweck, eine Streuung der Ansprechempfindlichkeit des Näherungssensors nachträglich zu beseitigen, um innerhalb einer Baureihe in einem oder in mehreren Fadenliefergeräten ein identisches Ansprechverhalten der Näherungssensoren und gleiche Steuerungs-Voraussetzungen zu erhalten.

Dies gilt auch für den Geschwindigkeits- oder Zählsensor D in Fig. 1, dessen Sensorelement 16 mit einem verstellbaren Trimmkörper T (nicht gezeigt) zusammenwirkt.

Die Näherungssensoren H, insbesondere als Hallsensoren, können digital oder analog arbeiten.

## Patentansprüche

1. Fadenliefergerät (F) mit einem eine Antriebswelle (2) aufweisenden Gehäuse (1), einem mittels der Antriebswelle (2) drehbaren Aufwikelement (3), einer an der Antriebswelle (2) angeordneten Speichertrommel (5) mit einem Fadenvorrat (4), und mit wenigstens einem ein Sensorelement (16, 17) aufweisenden Näherungssensor (H), dessen Sensorelement auf einem Bewegungsbereich eines relativ zum Sensorelement beweglichen Körpers aus einem magnetischen und/oder elektromagnetischen Fluß leitendem Material, wie einem Magneten, ausgerichtet und durch diesen zum Anprechen bringbar ist, **dadurch gekennzeichnet**, daß der Näherungssensor (H) entweder ein außerhalb der Speichertrommel (5) stationär angeordneter und mit seinem Sensorelement (16, 17) auf den in der Speichertrommel durch den Fadenvorrat (4) relativ zum Sensorelement (16, 17) beweglichen Magneten (28) ausgerichteter Fadensensor (G) zum Abtasten der Größe des auf der Speichertrommel (5) aufgewickelten, verbrauchsabhängig variierenden Fadenvorrats (4), oder ein im Gehäuse (1) angeordneter und mit seinem Sensorelement (16) auf einen mit der Antriebswelle (2) oder dem Aufwickelelement (3) rotierenden Magneten (28) ausgerichteter Geschwindigkeits- oder Zählsensor (D) ist, und daß bei dem Sensorelement (16, 17) des Fadensensors (G) bzw. des Geschwindigkeits- und/oder Zählsensors (D) wenigstens ein in seinem relativen Abstand zum Sensorelement (16, 17) verstellbarer Trimmkörper (T, 26, 27) aus magnetischen und/oder elektromagnetischen Fluß leitendem Material vorgesehen ist, durch dessen Abstandsverstellung die Ansprechempfindlichkeit des Sensors (G, D) veränderbar ist.

2. Fadenliefergerät nach Anspruch 1, **dadurch gekennzeichnet**, daß der Trimmkörper (T, 26, 27) aus Metall besteht.

3. Fadenliefergerät nach Anspruch 1, **dadurch gekennzeichnet**, daß der Trimmkörper (T, 27) eine von außerhalb zugängliche, auf das Sensorelement (16) ausgerichtete Schraube (26) ist.

4. Fadenliefergerät nach Anspruch 1, **dadurch gekennzeichnet**, daß der Trimmkörper (27) an einer in einer Gewindebohrung (25) verschraubbaren Schraube (26) angeordnet ist.

5. Fadenliefergerät nach Anspruch 1, **dadurch gekennzeichnet,** daß der Trimmkörper (T, 26, 27), wenigstens ein Eingriffselement aufweist und in einer formschlüssig zum Eingriffselement passenden Drehaufnahme (25) drehbar angeordnet und durch Drehen entweder des Drehkörpers oder der Drehaufnahme in seinem Abstand zum Sensorelement (16, 17) verstellbar ist.

6. Fadenliefergerät nach Anspruch 3 oder 4, **dadurch gekennzeichnet**, daß das Sensorelement (16) an einer Halterung (22) an der Mündung der Gewindebohrung (25) vorgesehen ist, in welcher die Trimmkörperschraube angeordnet ist.

7. Fadenliefergerät nach einem der Anprüche 1 bis 6, **dadurch gekennzeichnet**, daß das Sensorelement (16, 17) ein Hallelement oder ein magnetoresistives oder induktives Sensorelement ist.

## Claims

1. A yarn feeder (F) comprising a housing (1) including a drive shaft (2), a winding on element (3) which is rotable by means of said drive shaft (2), a storage drum (5) which is arranged on said drive shaft (2) and includes a yarn store (4), and at least one proximity sensor (H) including a sensor element (16, 17), which sensor element is directed towards a motion area of a body of magnetic and/or electromagnetic flux conducting material, like a magnet, said body being movable in relation to said sensor element which responds to motions of said body, **characterized in** that said proximity sensor (H) either is a yarn sensor (G) for detecting the size of the yarn store (4) wound onto said storage drum (5) and varying in dependence on consumption, said yarn sensor (G) being mounted stationarily outside of said storage drum (5) and being directed with its sensor element (16,17) towards said magnet (28) provided in said storage drum and being movable by said yarn store (4) relative to said sensor element (16, 17), or a speed-or counting sensor (D) provided in said housing (1) and directed with its sensor element (16) towards a magnet (28) rotating with said drive shaft (2) or said winding on element (3), respectively, and that close to said sensor element (16,17) of said yarn sensor (G) or said speed- and/or counting sensor (D), respectively, at least one trimming body (T, 26, 27) of magnetic and/or electromagnetic flux conducting material is provided, which is adjustable in its relative distance from said sensor element (16, 17), such that by means of said distance adjustment the response sensitivity of the respective sensor (G, D) is variable.

2. The yarn feeder as in claim 1, **characterized in** that said trimming body (T, 26, 27) consists of metal.

3. The yarn feeder as in claim 1, **characterized in** that said trimming body (T, 27) is a screw (26) directed towards said sensor element (16) and being accessible from the outside.

4. The yarn feeder as in claim 1, **characterized in** that said trimming body (27) is provided on a screw (26) which is screwable in a threaded bore (25).

5. The yarn feeder as in claim 1, **characterized in** that said trimming body (T, 26, 27) includes at least one engagement element and is rotatably provided in a rotation socket fitting by its form to said engagement element, and that the distance of said trimming body from said sensor element (16,17) can be adjusted either by rotating the tumable body or the rotation socket.

6. The yarn feeder as in claims 3 or 4, **characterized in** that said sensor element (16) is provided on a holder (22) at the mouth of said threaded bore (25) in which said trimming body screw is arranged.

7. The yarn feeder as in one of claims 1 to 6, **characterized in** that said sensor element (16,17) is a Hall element or a magneto-resistive or inductive sensor element.

## Revendications

1. Fournisseur de fil (F) comprenant un boîtier (1) équipé d'un arbre de commande (2), un enrouleur (3) susceptible de tourner par l'intermédiaire de l'arbre de commande (2), un tambour de stockage (5), monté sur l'arbre de commande (2) et muni d'une réserve de fil (4), et au moins un détecteur de proximité (H) muni d'un élément capteur (16, 17), qui est orienté vers une zone de mouvement d'un corps mobile par rapport à l'élément capteur et est réalisé dans un matériau conducteur de flux magnétique et/ou de flux électromagnétique, tel un aimant, par lequel ledit détecteur de proximité peut être activé, caractérisé en ce que le détecteur de proximité (H) est formé soit par un capteur de fil (G), monté de manière fixe en dehors du tambour de stockage (5) et orienté avec son élément capteur (16, 17) vers l'aimant (28) mobile dans le tambour de stockage par rapport à l'élément capteur (16, 17) au moyen de la réserve de fil (4), lequel capteur de fil est destiné à analyser la valeur de la réserve de fil (4) enroulée sur le tambour de stockage (5) et variant en fonction de l'utilisation, soit par un capteur de vitesse ou de comptage (D) monté dans le boîtier (1) et orienté avec son élément capteur (16) vers un aimant (28) tournant avec l'arbre de commande (2) ou l'enrouleur (3), et en ce qu'il est prévu près de l'élément capteur (16, 17) du capteur de fil (G) ou du capteur de vitesse et/ou de comptage (D) au moins un corps de centrage (T, 26, 27), qui est réalisé dans un matériau conducteur de flux magnétique et/ou électromagnétique et dont la distance est réglable par rapport à l'élément capteur (16, 17), le réglage de cette distance permettant de faire varier la sensibilité d'activation du détecteur (G, D).

2. Fournisseur de fil selon la revendication 1, caractérisé en ce que le corps de centrage (R, 26, 27) est réalisé en métal.

3. Fournisseur de fil selon la revendication 1, caractérisé en ce que le corps de centrage (T, 27) est une vis (26) accessible de l'extérieur et orientée vers l'élément capteur (16).

4. Fournisseur de fil selon la revendication 1, caractérisé en ce que le corps de centrage (27) est posé contre une vis (26) qui peut être vissée dans un trou taraudé (25).

5. Fournisseur de fil selon la revendication 1, caractérisé en ce que le corps de centrage (T, 26, 27) est muni d'au moins un élément de prise et est disposé de manière à pouvoir tourner dans un logement de rotation (25) ajusté pour un assemblage par conjugaison de forme avec l'élément de prise, et sa distance par rapport à l'élément capteur (16, 17) peut être réglée par la rotation du corps de rotation ou du logement de rotation.

6. Fournisseur de fil selon la revendication 3 ou 4, caractérisé en ce que l'élément capteur (16) est prévu contre un support (22), au niveau de l'orifice du trou taraudé (25), dans lequel est disposée la vis du corps de centrage.

7. Fournisseur de fil selon l'une quelconque des revendications 1 à 6, caractérisé en ce que l'élément capteur (16, 17) est un capteur à effet Hall ou un capteur inductif ou à résistivité magnétique.
